(19) **Europäisches Patentamt / European Patent Office / Office européen des brevets**

(11) **EP 2 436 513 B1**

(12) **FASCICULE DE BREVET EUROPEEN**

(45) Date de publication et mention de la délivrance du brevet:
**27.11.2013 Bulletin 2013/48**

(51) Int Cl.:
*B29C 71/02* (2006.01)    *H01L 21/50* (2006.01)
*H01L 29/51* (2006.01)

(21) Numéro de dépôt: **11306077.6**

(22) Date de dépôt: **29.08.2011**

(54) **Réalisation d'un système déformable en vue du déplacement d'un objet enfermé dans celui-ci**

Herstellungsverfahren eines Systems, das zwecks der Verschiebung eines in ihm eingeschlossenen Gegenstandes verformbar ist

Production of a deformable system in order to move an object contained therein

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **30.09.2010 FR 1057913**

(43) Date de publication de la demande:
**04.04.2012 Bulletin 2012/14**

(73) Titulaire: **COMMISSARIAT A L'ENERGIE ATOMIQUE ET AUX ENERGIES ALTERNATIVES**
**75015 Paris (FR)**

(72) Inventeurs:
• **Benwadih, Mohammed**
**94500 CHAMPIGNY SUR MARNE (FR)**

• **Bablet, Jacqueline**
**38450 LE GUA (FR)**
• **Coronel, Philippe**
**38530 BARRAUX (FR)**

(74) Mandataire: **Vuillermoz, Bruno et al**
**Cabinet Laurent & Charras**
**"Le Contemporain"**
**50, Chemin de la Bruyère**
**69574 Dardilly Cédex (FR)**

(56) Documents cités:
**EP-A1- 2 105 940    EP-A2- 2 014 611**
**US-A- 5 463 233**

## Description

### DOMAINE DE L'INVENTION

La présente invention propose un procédé permettant de déplacer un objet intégré dans un système solide. Ce procédé consiste à ramollir de manière transitoire le milieu dans lequel est placé l'objet, puis à déplacer l'objet par application d'une action ou d'une contrainte extérieure.

Avantageusement, la présente invention trouve application dans le domaine de l'électronique, par exemple pour l'élaboration de connexions variables ou la fabrication de transistor à capacitance variable.

### ETAT ANTERIEUR DE LA TECHNIQUE

Les dispositifs solides intégrant plusieurs composants présentent l'inconvénient d'être figés, dans la mesure où la position relative des différents composants est fixée.

L'intérêt de rendre plus flexible ces dispositifs est évident, notamment dans le domaine de l'électronique.

Ainsi, une même batterie dans un système pourrait établir plusieurs points de connexion, permettant ainsi d'alimenter plusieurs objets situés à des endroits différents, si son déplacement était rendu possible.

Dans le contexte des transistors à effet de champ organique, il est connu que la capacitance dépend de la distance grille-oxyde. Ainsi, la possibilité de modifier cette distance en déplaçant la grille permettrait d'obtenir des transistors à capacitance variable.

Il existe donc un besoin réel de développer des solutions techniques pour déplacer un objet ou composant au sein d'un système ou dispositif solide.
Le document EP-A2-2 014 611 décrit un procédé de déplacement d'un objet au sein d'un système solide.

### EXPOSE DE L'INVENTION

La présente invention repose sur l'utilisation de matériaux, notamment polymères, ayant une faible température de fusion (Tf) et/ou une faible température de transition vitreuse (Tg), comme matrice pour insérer un objet en vue de le déplacer, en jouant sur la température solide-liquide de cette matrice.

Plus précisément, la présente invention concerne un procédé de déplacement d'un objet au sein d'un système solide, qui comprend les étapes suivantes :

- disposer l'objet au sein d'une matrice, ladite matrice étant solide à une première température et susceptible de ramollissement sous l'effet de l'élévation de la température ;
- si nécessaire élever la température jusqu'à ramollissement de la matrice ;
- appliquer une action extérieure sur l'objet de manière à le déplacer au sein de la matrice ramollie ;
- abaisser la température jusqu'à la solidification de la matrice.

Comme déjà dit, la présente invention trouve avantageusement application dans le domaine de l'électronique voire de la microélectronique. Les objets concernés sont par exemple des nanofils de silicium, des nanotubes de carbone, des microbatteries, micropiles, des connecteurs, des lentilles optiques, des électrodes de transistor ou des filtres optiques. De manière avantageuse dans ce contexte, l'objet est constitué d'un matériau conducteur.

Il apparaît que la matrice est ramollie de manière transitoire de manière à autoriser le déplacement de l'objet puis, à l'issue du déplacement, est à nouveau solidifiée pour figer le système.

Dans le cadre de l'invention, la matrice n'a pas nécessairement de fonctionnalité dans le système solide autre que celle de permettre le déplacement de l'objet. Avantageusement et en pratique, ceci signifie que :

- l'objet est immergé dans ladite matrice ;
- la matrice occupe le volume nécessaire au déplacement.

En revanche et avantageusement, un élément fonctionnel du système solide autre que l'objet est un substrat. Selon un mode de réalisation privilégié, l'objet est donc disposé dans une cavité aménagée dans un substrat, puis est recouvert ou enfoui dans la matrice qui, à ce stade, peut aussi bien être sous forme solide que liquide.

Ainsi et préférentiellement, la matrice vient remplir la totalité de la cavité. En d'autres termes, le volume de la matrice correspond au volume de la cavité, auquel est retranché le volume de l'objet.

De fait, la cavité est de dimensions variables en fonction du déplacement et de la taille de l'objet à déplacer. Ainsi et à titre d'exemple :

- si l'objet est une microbatterie destinée à alimenter deux objets à des endroits différents, la cavité aura des dimensions de l'ordre du déplacement de 500 $\mu$m à 10 mm, voire 50 mm ;
- si l'objet est un nanofil de silicium pour jouer le rôle de grille flottante, pour connecter ou pour former court-circuit, le déplacement peut être de l'ordre de 1 $\mu$m jusqu'à 100 $\mu$m.

Il apparaît que pour qu'un tel système fonctionne, un certain nombre de contraintes en termes de température existe sur la nature des matériaux mis en oeuvre :

- l'ensemble du système doit être solide à la température d'intérêt, généralement la température de fonctionnement, qui correspond avantageusement à la température ambiante (20 à 30°C) ;

- à la température de ramollissement de la matrice, l'objet mais également les autres composants du système solide, et notamment le substrat, doivent demeurer fonctionnels et notamment à l'état solide.

En pratique, la matrice doit donc présenter une température de ramollissement peu élevée. Des matériaux particulièrement bien adaptés pour constituer la matrice selon l'invention appartiennent à la classe des polymères.

Parmi les polymères, on distingue plusieurs classes dont les polyesters, les polyamides, les acryliques, les styréniques, les polyuréthanes, ou les polyimides.

Des matériaux préférés dans le cadre de l'invention sont par exemple :

- des copolymères d'éthylène et d'acrylate de méthyle qui ont une température de fusion inférieure à 95°C, ou
- des copolymères d'éthylène et d'acétate de vinyle, qui ont une température de fusion inférieure à 75°C.

Ceux-ci peuvent bien sûr être utilisés en mélange.

Tout autre polymère présentant une température de fusion peu élevée, avantageusement inférieure à 200°C, peut être utilisée ainsi que des matériaux dont la transition solide-liquide est comprise entre -50°C et 200°C, par exemple l'eau.

Dans le cadre de l'invention, on entend par « température de ramollissement », la température à laquelle le matériau en présence perd son état solide pour tendre vers l'état liquide. En pratique, cette température correspond à la température de fusion (Tf) et/ou à la température de transition vitreuse (Tg).

Pour rappel, ces deux températures peuvent conditionner l'état physique d'un matériau :

- la température de transition vitreuse (Tg) sépare le comportement vitreux à T<Tg(solide) de l'état caoutchouteux ou élastomère à T>Tg(liquide). Cette température s'étend sur un domaine important pour les polymères ;
- la température de fusion (Tf) et son contraire, la température de cristallisation. Naturellement, ces températures n'ont de sens que si le matériau considéré est susceptible de cristalliser.

La transition vitreuse est un phénomène important qui conditionne le comportement physique en fonction de la température des systèmes non cristallisés. En effet c'est le passage du comportement de type solide (verre) vers le comportement de type liquide.

Les facteurs influençant la température Tg sont bien connus de l'homme du métier et sont pas exemple la rigidité de la chaine macromoléculaire, les interactions interchaînes, l'encombrement ou la flexibilité des groupes latéraux et la masse molaire.

Par ailleurs, il peut exister une corrélation entre ces deux températures Tg et Tf, dans le cas où le polymère considéré est cristallisable. Les facteurs chimiques qui contrôlent la température Tg ont aussi un effet sur la température Tf car ces deux températures sont essentiellement contrôlées par la rigidité des chaines macromoléculaires.

Comme déjà dit, la température de ramollissement (Tg ou Tf) de la matrice doit notamment être inférieure à celle du substrat. En pratique, le matériau constitutif du substrat est avantageusement un plastique, encore plus avantageusement du polyéthylène naphtalate (PEN), ou le matériau constituant les PCB (acronyme anglais pour *« Printed Circuit Board »)* à base de polyimide. En effet, le PEN présente une température de transition vitreuse, Tg, de l'ordre de 120°C et une température de fusion, Tf, supérieure à 250°C.

De manière privilégiée selon l'invention, pour assurer une stabilité thermique au système, le couple matrice (avantageusement polymère)/substrat (avantageusement plastique) est choisi de telle sorte que la différence entre leurs températures de transition vitreuse (Tg) et/ou de fusion (Tf) soit supérieure ou égale à 50°C, encore plus avantageusement comprise entre 70 et 100°C.

Pour compléter le système, une couche, de type film ou membrane plastique, peut servir à couvrir ou encapsuler la matrice et/ou le substrat, de manière partielle ou totale. Ainsi, cette couche peut être appliquée sur la cavité remplie de matrice, par toute technique classique telle que le collage. La nature de cette couche ou membrane est choisie de manière à ne pas empêcher l'action extérieure permettant le déplacement de l'objet.

Comme déjà dit, le déplacement de l'objet est réalisé par application d'une action extérieure. Il peut s'agir d'une action de nature électrique (par électrophorèse ou application d'un champ électrique), magnétique (exercée à l'aide d'un aimant) ou mécanique (par exemple grâce à la pesanteur en renversant le système).

L'utilisation d'un aimant est un mode de réalisation privilégié selon l'invention. En fonction de la force dudit aimant et de la viscosité de la matrice, il est ainsi possible de moduler le déplacement de l'objet.

L'objet doit, bien sûr, être susceptible d'être déplacé par l'action appliquée. Il peut donc être nécessaire de le recouvrir au moins partiellement d'une couche ou d'un dépôt le rendant par exemple magnétique ou conducteur électrique.

Le déplacement de l'objet au sein de la matrice peut être réalisé dans les trois dimensions, par exemple dans un plan vertical ou horizontal par rapport à la surface du substrat.

Lorsque le déplacement souhaité a été réalisé, la température du système est abaissée de manière à ce que la matrice redevienne solide et le système figé. Toutefois, il est possible de réitérer ce cycle de montée/descente en température du même système, à chaque fois que l'obj et doit subir un déplacement.

Comme déjà dit, la présente invention présente un intérêt tout particulier dans le domaine de l'électronique. De ce fait et selon un autre aspect de l'invention, celle-ci concerne un dispositif électronique comportant un objet susceptible d'être déplacé à l'aide du procédé décrit ci-avant.

Plus précisément, la présente invention trouve deux applications particulièrement adaptées.

Selon un premier aspect, l'invention propose un procédé d'établissement de connexions variables entre un objet, avantageusement une microbatterie, et deux points d'alimentation (A, B) d'un système solide, consistant à déplacer l'objet entre les points A et B situés au niveau de la cavité du substrat par la mise en oeuvre du procédé revendiqué. Pour que la connexion électrique soit effective, il faut que les lignes de connexion passent par lesdits points A et B. Selon un mode de réalisation privilégié, les parois de la cavité sont donc recouvertes, au moins au niveau des points A et B d'une couche conductrice électrique permettant l'alimentation.

En d'autres termes, l'invention concerne un procédé d'établissement de connexions entre un objet, avantageusement une microbatterie, et au moins deux points d'alimentation (A, B) d'un système, qui comprend les étapes suivantes :

- disposer la microbatterie au sein d'une cavité, aménagée dans un substrat et dont les parois sont recouvertes au moins partiellement d'une couche métallique ;
- remplir la cavité à l'aide d'une matrice, solide à une première température et susceptible de ramollissement sous l'effet de l'élévation de la température ;
- si nécessaire élever la température jusqu'à ramollissement de la matrice ;
- appliquer une action extérieure sur la microbatterie de manière à la déplacer au sein de la matrice jusqu'à un point A ou B situé au niveau de la cavité métallisée du substrat ;
- abaisser la température jusqu'à solidification de la matrice.

Dans ce procédé, la matrice est avantageusement réalisée en polymère, la température étant élevée jusqu'à la température de transition vitreuse (Tg) et/ou de fusion (Tf) dudit polymère. Il peut notamment s'agir de copolymère d'éthylène et d'acrylate de méthyle ou de copolymère d'éthylène et d'acétate de vinyle.

Par ailleurs, le substrat doit présenter une température de ramollissement supérieure à celle de la matrice, la différence entre les deux températures étant avantageusement supérieure ou égale à 50°C, encore plus avantageusement comprise entre 70 et 100°C.

Ainsi, le substrat est avantageusement réalisé à l'aide d'un matériau plastique, par exemple du PEN (polyéthylène naphtalate) ou du matériau des PCB à base de polyimide.

Un couple de matériaux polyéthylène naphtalate pour le substrat / copolymère d'éthylène et d'acrylate de méthyle pour la matrice est parfaitement adapté à la présente application. Dans ce cas de figure, la température du système est élevée jusqu'à 75°C.

Un tel système est avantageusement scellé par collage d'un film ou d'une membrane plastique permettant de boucher la cavité. En d'autres termes, la matrice, et éventuellement le substrat, est recouverte ou encapsulée à l'aide d'une couche.

Pour déplacer la microbatterie, une action électrique ou magnétique peut être appliquée. Le déplacement de la microbatterie est avantageusement réalisé dans un plan horizontal, à l'aide d'un aimant. La face de la microbatterie en regard de l'aimant est alors recouverte d'un dépôt magnétique.

L'invention vise donc un dispositif électronique comprenant une microbatterie placée dans une cavité d'un substrat, les parois de la cavité étant recouvertes, au moins partiellement, d'une couche conductrice permettant d'établir différents points de connexion (A, B). Ainsi, la batterie est capable d'alimenter, de manière alternative, les dispositifs reliés par une ligne de connexion aux points A et B.

Selon un autre aspect, l'invention concerne un procédé de réalisation d'un transistor à capacitance variable consistant à déplacer la grille du transistor (correspondant alors à l'objet) par la mise en oeuvre du procédé revendiqué.

En d'autres termes, l'invention concerne un procédé de réalisation d'un transistor à capacitance variable comprenant les étapes suivantes :

- disposer l'électrode grille au sein d'une cavité aménagée dans un substrat ;
- remplir la cavité à l'aide d'une matrice, solide à une première température et susceptible de ramollissement sous l'effet de l'élévation de la température ;
- si nécessaire élever la température jusqu'à ramollissement de la matrice ;
- appliquer une action extérieure sur la grille de manière à la déplacer au sein de la matrice ramollie ;
- abaisser la température jusqu'à solidification de la matrice.

Dans le contexte d'un tel transistor, l'objet, en l'occurrence l'électrode grille, est avantageusement une lame de fer ou en aluminium.

Un tel transistor est également doté d'électrodes source et drain et d'un matériau semiconducteur, déposés à la surface du substrat, sur la face opposée à celle sur laquelle est disposée la grille.

Les électrodes source et drain sont réalisées, de manière classique, par métallisation et se présentent sous la forme d'un dépôt d'or, par exemple de 30 nm d'épaisseur. Comme pour la grille, les électrodes source et/ou drain peuvent également être déplacée selon l'invention de manière à modifier les dimensions du canal du transistor.

Dans ce procédé, la matrice est avantageusement réalisée en polymère, la température étant élevée jusqu'à la température de transition vitreuse (Tg) et/ou de fusion (Tf) dudit polymère. Il peut notamment s'agir de copolymère d'éthylène et d'acrylate de méthyle ou de copolymère d'éthylène et d'acétate de vinyle.

Par ailleurs, le substrat doit présenter une température de ramollissement supérieure à celle de la matrice, la différence entre les deux températures étant avantageusement supérieure ou égale à 50°C, encore plus avantageusement comprise entre 70 et 100°C. Ainsi, le substrat est avantageusement réalisé à l'aide d'un matériau plastique, par exemple du PEN (polyéthylène naphtalate).

Un couple de matériaux polyéthylène naphtalate pour le substrat / copolymère d'éthylène et d'acrylate de méthyle pour la matrice est parfaitement adapté à la présente application. Dans ce cas de figure, la température du système est élevée jusqu'à 75°C.

Un tel système est avantageusement fermé par collage d'une membrane permettant de boucher la cavité. En d'autres termes, la matrice, et éventuellement le substrat, est recouverte ou encapsulée à l'aide d'une couche.

Pour déplacer la grille, une action électrique ou magnétique peut être appliquée. Le déplacement de la grille est avantageusement réalisé dans un plan vertical, à l'aide d'un aimant. Toutefois, il est possible de la déplacer dans les trois directions. Il est ainsi possible de moduler l'épaisseur du diélectrique ou de modifier la distance de la grille vis-à-vis de l'électrode source ou drain. Il en résulte une modification des performances électriques, notamment de la capacitance du transistor.

L'invention vise donc également un dispositif électrique correspondant à un transistor dont la capacitance est rendue variable grâce au déplacement de l'électrode grille et à sa position relative dans le transistor. De même, on peut réaliser des résistances variables en déplaçant une barre conductrice sur un réseau de motifs, pour contacter en série un nombre défini de motifs et ainsi constituer une résistance variable.

L'objet peut aussi être un élément optique dont l'orientation permet de modifier les caractéristiques d'un faisceau lumineux. Par exemple, l'élément peut être un miroir qui défléchit la lumière selon son inclinaison par rapport à la direction du faisceau. Ce peut être un filtre pour atténuer plus ou moins l'intensité de la lumière ou pour sélectionner ou non certaines longueurs d'onde.

Selon un autre aspect, l'invention concerne donc un procédé de réalisation d'un dispositif optique modulable qui comprend les étapes suivantes :

- disposer un élément optique au sein d'une cavité aménagée dans un substrat ;
- remplir la cavité à l'aide d'une matrice, solide à une première température et susceptible de ramollissement sous l'effet de l'élévation de la température ;
- si nécessaire élever la température jusqu'à ramollissement de la matrice ;
- appliquer une action extérieure sur l'élément de manière à le déplacer au sein de la matrice ;
- abaisser la température jusqu'à solidification de la matrice .

## BREVE DESCRIPTION DES FIGURES

La manière dont l'invention peut être réalisée et les avantages qui en découlent ressortiront mieux des exemples de réalisation qui suivent, donnés à titre indicatif et non limitatif, à l'appui des figures annexées parmi lesquelles :

La figure 1 illustre la mise en oeuvre du procédé selon l'invention pour la réalisation d'une connexion variable.
La figure 2 illustre la mise en oeuvre du procédé selon l'invention pour la fabrication d'un transistor à capacitance variable.

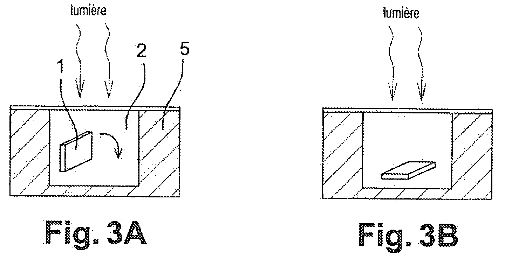

La figure 3 illustre un dispositif optique modulable grâce à la mise en oeuvre du procédé selon l'invention, avec une première position (A) et une seconde position (B) de l'élément optique.

## MODES DE REALISATION DE L'INVENTION

### *1/ Réalisation d'une connexion variable :*

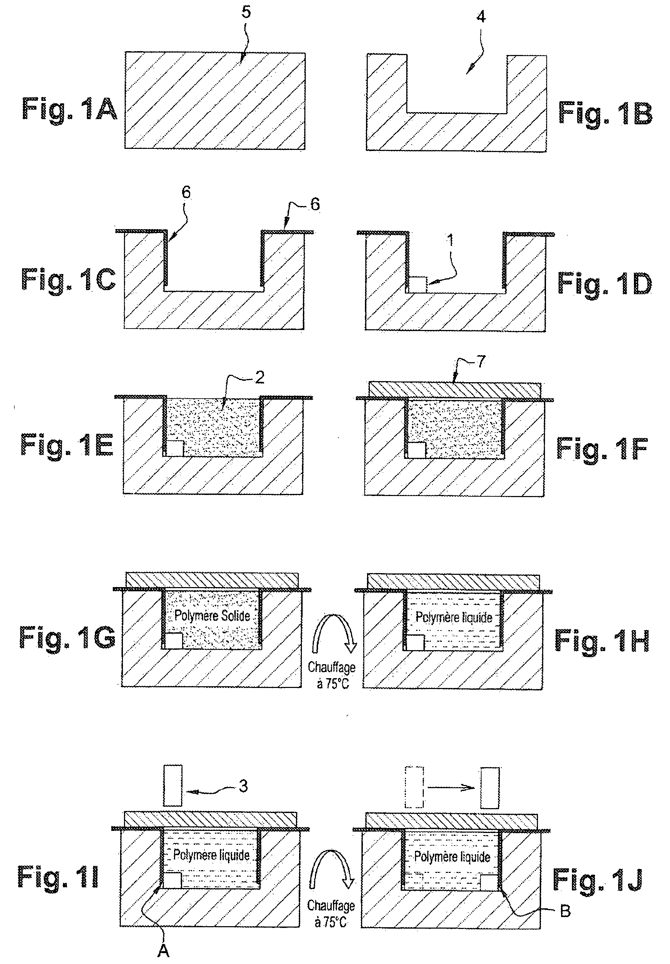

Ce mode de réalisation particulier, permettant de connecter par exemple une microbatterie alternativement à un point A et à un point B, est illustré plus avant à la figure 1.

Etape 1 (Fig. 1A et 1B) :

On embosse ou grave du polyéthylène naphtalate (Tg = 120°C) qui sert de substrat (5), par exemple d'épaisseur 125 $\mu$m.

La cavité (4) obtenue est de dimension variable en fonction du déplacement et de la taille de l'objet (1) à déplacer.

Etape II (Fig. 1C) :

Dans le cas où un contact électrique est à établir entre le substrat (5) et l'objet (1), les bords de la cavité sont métallisés à l'aide d'une couche métallique (6) assurant la ligne de connexion.

Etape III (Fig. 1D) :

On inserre alors l'objet (1) à déplacer dans la cavité (4) aménagée à cet effet.

Etape IV (Fig. 1E) :

On remplit la cavité (4) à l'aide du polymère à faible Tf et/ou Tg servant de matrice (2), à l'état liquide ou solide, de sorte à recouvrir l'objet à déplacer (1). Par exemple, le polymère est un copolymère d'éthylène et d'acrylate de méthyle qui présente une température de fusion inférieure à 70°C. En l'occurrence, il devient liquide à partir de 50°C.

Etape V (Fig. 1F) :

On rebouche la cavité (4) par un autre film ou une membrane plastique (7) par collage, de manière à encapsuler et fermer le système.

Etape VI (Fig. 1 G et 1H) :

On élève la température du système de la température ambiante à une température où le polymère servant de matrice (2) se ramollit, ici à une température de 75°C assurant le passage de l'état solide à l'état liquide du seul polymère.

Il faut une différence de température entre la température de transition vitreuse (Tg) du plastique (substrat, 5) et la température de fusion (Tf) du polymère (2) d'environ 75°C pour obtenir une stabilité thermique du système. Un minimum de 50°C semble être une valeur acceptable.

Etape VII (Fig. 1I et 1J) :

On utilise un aimant (3) pour déplacer l'objet (1) dans la phase liquide du polymère (2), d'un point de connexion A à l'autre point B. La face de la microbatterie (1) est couverte à cet effet d'un dépôt magnétique pour pouvoir être aimantée.

Pour déplacer l'objet, à la place du magnétisme, on peut utiliser d'autres méthodes telles qu'un champ électrique, une di-électrophorèse, une action mécanique, ou la pesanteur en mettant le système à la verticale.

### 2/ Fabrication d'un transistor à capacitance variable :

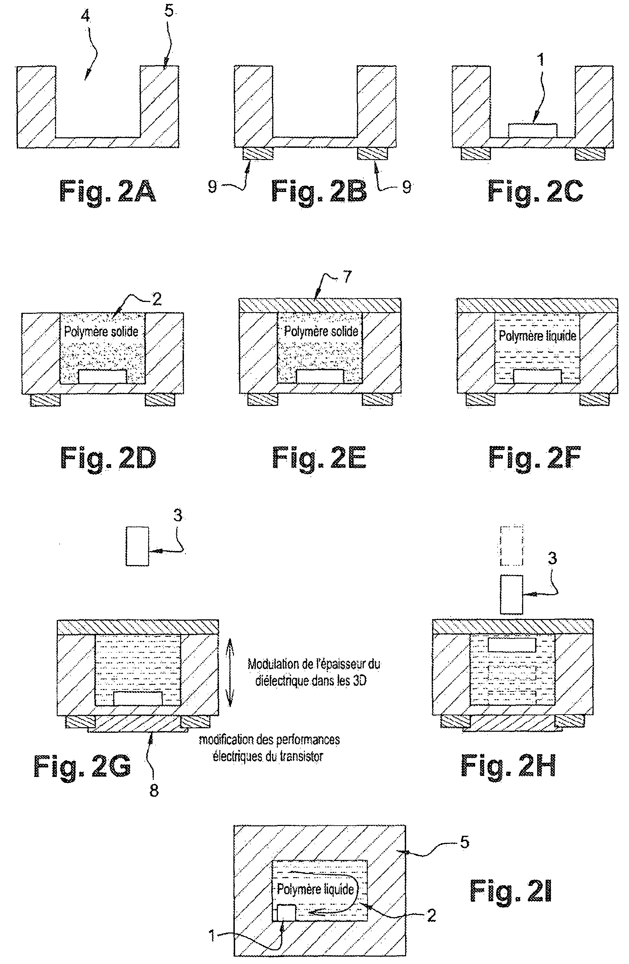

Ce mode de réalisation particulier, permettant de fabriquer un transistor à effet de champ organique à capacitance variable, est illustré plus avant à la figure 2.

Le procédé selon l'invention est mis en oeuvre pour faire déplacer, dans une matrice polymère en fusion, l'électrode de grille. Grâce à la distance grille-oxyde variable, il est possible de modifier la capacitance du transistor.

Etape 1 (Fig. 2A) :

On embosse ou grave une cavité (4) dans du polyéthylène naphthalate qui sert de substrat (5).

Etape II (Fig. 2B) :

On réalise les électrodes source et drain (9) par métallisation, à l'aide d'un dépôt de 30 nm d'Au.

Etape III (Fig. 2C) :

On inserre alors l'objet (1) à déplacer, en l'occurrence une grille flottante constituée d'une lame de fer, dans la cavité (4) aménagée à cet effet.

Etape IV (Fig. 2D) :

On remplit la cavité (4) à l'aide du polymère à faible Tf et/ou Tg servant de matrice (2), à l'état liquide ou solide, de sorte à recouvrir l'objet à déplacer (1). Par exemple, le polymère est un copolymère d'éthylène et d'acrylate de méthyle qui présente une température de fusion inférieure à 70°C. En l'occurrence, il devient liquide à partir de 50°C.

Etape V (Fig. 2E) :

On rebouche la cavité (4) avec une membrane (7), de manière à encapsuler et fermer le système.

Etape VI (Fig. 2F) :

On élève la température du système de la température ambiante à une température où le polymère servant de matrice (2) se ramollit, ici à une température de 75°C assurant le passage de l'état solide à l'état liquide du seul polymère.

Etape VII (Fig. 2G et 2H) :

Une couche semi-conductrice (8) est placé entre les électrodes source et drain (6').

On utilise un aimant (3) pour déplacer l'objet (1) dans la phase liquide du polymère (2). Le déplacement de la grille permet de moduler l'épaisseur du diélectrique dans les trois dimensions. Il en résulte une modification des performances électriques du transistor selon la formule suivante :

$$C_{ox} = \varepsilon_r \varepsilon_0 S/e$$

La figure 2I est une vue de dessus du système: la grille (1) peut se déplacer dans les 3 dimensions dans le polymère fondu (2).

Il ressort de ce qui précède que le procédé revendiqué peut être utilisé pour modéliser le comportement du transistor dans les trois dimensions, soit en se rapprochant de la source ou du drain pour comprendre la physique associée cette structure, ou plus généralement pour étudier tout type de phénomène engendré par la modification de l'emplacement de la grille dans la structure transistor.

On peut en fonction de la viscosité du polymère jouer sur le déplacement de la grille. En effet, la distance de déplacement du métal enfoui (1) dépend de la viscosité du polymère (2) et de la force de l'aimant (3).

**Revendications**

1. Procédé de déplacement d'un objet au sein d'un système solide comprenant les étapes suivantes :

   - disposer l'objet (1) au sein d'une matrice (2), solide à une première température et susceptible de ramollissement sous l'effet de l'élévation de la température ;
   - si nécessaire élever la température jusqu'à ramollissement de la matrice (2) ;
   - appliquer une action extérieure sur l'objet (1) de manière à le déplacer au sein de la matrice (2) ;
   - abaisser la température jusqu'à solidification de la matrice (2).

2. Procédé de déplacement d'un objet selon la revendication 1, *caractérisé* **en ce que** l'objet (1) est choisi dans le groupe suivant : nanofils de silicium, nanotubes de carbone, microbatterie, micropile, connecteur, lentille optique, électrode de transistor, filtre optique.

3. Procédé de déplacement d'un objet selon l'une des revendications 1 et 2, *caractérisé* **en ce que** la matrice (2) est réalisée en polymère, la température étant élevée jusqu'à la température de transition vitreuse (Tg) et/ou de fusion (Tf) dudit polymère.

4. Procédé de déplacement d'un objet selon la revendication 3, *caractérisé* **en ce que** la matrice (2) est réalisée à l'aide de copolymère d'éthylène et d'acrylate de méthyle ou de copolymère d'éthylène et d'acétate de vinyle.

5. Procédé de déplacement d'un objet selon l'une des revendications précédentes, *caractérisé* **en ce qu'**une action électrique ou magnétique, avantageusement exercée à l'aide d'un aimant (3), est appliquée.

6. Procédé de déplacement d'un objet selon l'une des revendications précédentes, *caractérisé* **en ce que** l'objet (1) est disposé dans une cavité (4) aménagée dans un substrat (5) puis remplie de matrice (2).

7. Procédé de déplacement d'un objet selon la revendication 6, *caractérisé* **en ce que** le substrat (5) présente une température de ramollissement supérieure à celle de la matrice (2), la différence entre les deux températures étant avantageusement supérieure ou égale à 50°C.

8. Procédé de déplacement d'un objet selon la revendication 6 ou 7, *caractérisé* **en ce que** le substrat (5) est réalisé à l'aide d'un matériau plastique, avantageusement du PEN (polyéthylène naphtalate) ou le polyimide.

9. Procédé de déplacement d'un objet selon l'une des revendications précédentes, *caractérisé* **en ce que** la matrice (2), et éventuellement le substrat (5), est recouverte ou encapsulée à l'aide d'une couche (7).

10. Procédé d'établissement de connexions variables entre un objet, avantageusement une microbatterie, et au moins deux points d'alimentation (A, B) d'un système comprenant les étapes suivantes :

    - disposer l'objet (1) au sein d'une cavité (4), aménagée dans un substrat (5) et dont les parois sont recouvertes au moins partiellement d'une couche métallique (6) ;
    - remplir la cavité (4) à l'aide d'une matrice (2), solide à une première température et susceptible de ramollissement sous l'effet de l'élévation de la température ;
    - si nécessaire élever la température jusqu'à ramollissement de la matrice (2) ;
    - appliquer une action extérieure sur l'objet (1) de manière à le déplacer au sein de la matrice (2) jusqu'à un point A ou B situé au niveau de la cavité (4) métallisée du substrat (5) ;
    - abaisser la température jusqu'à solidification de la matrice (2).

11. Procédé de réalisation d'un transistor à capacitance variable comprenant les étapes suivantes :

    - disposer l'électrode grille (1) au sein d'une cavité (4) aménagée dans un substrat (5) ;
    - remplir la cavité (4) à l'aide d'une matrice (2), solide à une première température et susceptible de ramollissement sous l'effet de l'élévation de la température ;
    - si nécessaire élever la température jusqu'à ramollissement de la matrice (2) ;
    - appliquer une action extérieure sur la grille (1) de manière à la déplacer au sein de la matrice (2) ;
    - abaisser la température jusqu'à solidification de la matrice (2).

12. Procédé de réalisation d'un dispositif optique modulable comprenant les étapes suivantes :

    - disposer un élément optique (1) au sein d'une cavité (4) aménagée dans un substrat (5) ;
- remplir la cavité (4) à l'aide d'une matrice (2), solide à une première température et susceptible de ramollissement sous l'effet de l'élévation de la température ;
- si nécessaire élever la température jusqu'à ramollissement de la matrice (2) ;
- appliquer une action extérieure sur l'élément (1) de manière à le déplacer au sein de la matrice (2) ;
- abaisser la température jusqu'à solidification de la matrice (2).

**Patentansprüche**

1. Verfahren zum Verlagern eines Gegenstands innerhalb eines festen Systems, die folgenden Schritte umfassend:

   - Anordnen des Gegenstands (1) innerhalb einer Matrix (2), die bei einer ersten Temperatur fest ist und unter der Wirkung einer Erhöhung der Temperatur erweichen kann;
   - nötigenfalls Erhöhen der Temperatur bis zum Erweichen der Matrix (2);
   - Einwirken auf den Gegenstand (1) von außen her, um ihn innerhalb der Matrix (2) zu verlagern;
   - Senken der Temperatur bis zur Erstarrung der Matrix (2).

2. Verfahren zum Verlagern eines Gegenstands nach Anspruch 1, **dadurch gekennzeichnet, dass** der Gegenstand (1) aus der folgenden Gruppe ausgewählt ist: Silicium-Nanodrähte, Kohlenstoff-Nanoröhrchen, Mikro-Akkumulator, Mikro-Batterie, Verbinder, optische Linse, Transistorelektrode, optisches Filter.

3. Verfahren zum Verlagern eines Gegenstands nach einem der Ansprüche 1 und 2, **dadurch gekennzeichnet, dass** die Matrix (2) aus Polymer hergestellt ist, wobei die Temperatur bis zur Glasübergangstemperatur (Tg) und/oder Schmelztemperatur (Tf) des Polymers erhöht wird.

4. Verfahren zum Verlagern eines Gegenstands nach Anspruch 3, **dadurch gekennzeichnet, dass** die Matrix (2) mittels Ethylen-Methylacrylat-Copolymer oder Ethylen-Vinylacetat-Copolymer hergestellt ist.

5. Verfahren zum Verlagern eines Gegenstands nach einem der vorhergehenden Ansprüche, **dadurch gekennzeichnet, dass** eine elektrische oder magnetische, vorteilhafter Weise mittels eines Magneten (3) ausgeübte Einwirkung angewendet wird.

6. Verfahren zum Verlagern eines Gegenstands nach einem der vorhergehenden Ansprüche, **dadurch gekennzeichnet, dass** der Gegenstand (1) in einem Hohlraum (4) angeordnet wird, der in einem Substrat (5) ausgebildet ist und dann mit der Matrix (2) gefüllt wird.

7. Verfahren zum Verlagern eines Gegenstands nach einem der vorhergehenden Ansprüche, **dadurch gekennzeichnet, dass** das Substrat (5) eine Erweichungstemperatur aufweist, die höher ist als diejenige der Matrix (2), wobei der Unterschied zwischen den zwei Temperaturen vorteilhafter Weise höher als oder gleich 50°C ist.

8. Verfahren zum Verlagern eines Gegenstands nach Anspruch 6 oder 7, **dadurch gekennzeichnet, dass** das Substrat (5) mittels eines Kunststoffs, vorteilhafter Weise PEN (Polyethylennaphthalat) oder Polyimid hergestellt ist.

9. Verfahren zum Verlagern eines Gegenstands nach einem der vorhergehenden Ansprüche, **dadurch gekennzeichnet, dass** die Matrix (2), und gegebenenfalls das Substrat (5), mittels einer Schicht (7) bedeckt oder eingekapselt wird.

10. Verfahren zum Herstellen variabler Verbindungen zwischen einem Gegenstand, vorteilhafter Weise einem Mikro-Akkumulator, und mindestens zwei Versorgungspunkten (A, B) eines Systems, die folgenden Schritte umfassend:

    - Anordnen des Gegenstands (1) innerhalb eines Hohlraums (4), der in einem Substrat (5) ausgebildet ist, und dessen Wände zumindest teilweise mit einer Metallschicht (6) bedeckt sind;
    - Füllen des Hohlraums (4) mittels einer Matrix (2), die bei einer ersten Temperatur fest ist und unter der Wirkung einer Erhöhung der Temperatur erweichen kann;
    - nötigenfalls Erhöhen der Temperatur bis zum Erweichen der Matrix (2);
    - Einwirken auf den Gegenstand (1) von außen her, um ihn innerhalb der Matrix (2) bis zu einem Punkt A oder B zu verlagern, der sich im Bereich des metallbedeckten Hohlraums (4) des Substrats (5) befindet;
    - Senken der Temperatur bis zur Erstarrung der Matrix (2).

11. Verfahren zum Herstellen eines Transistors mit variabler Kapazitanz, die folgenden Schritte umfassend:

    - Anordnen der Gitterelektrode (1) innerhalb eines Hohlraums (4), der in einem Substrat (5) ausgebildet ist;

- Füllen des Hohlraums (4) mittels einer Matrix (2), die bei einer ersten Temperatur fest ist und unter der Wirkung einer Erhöhung der Temperatur erweichen kann;
- nötigenfalls Erhöhen der Temperatur bis zum Erweichen der Matrix (2);
- Einwirken auf die Gitterelektrode (1) von außen her, um sie innerhalb der Matrix (2) zu verlagern;
- Senken der Temperatur bis zur Erstarrung der Matrix (2).

12. Verfahren zum Herstellen einer modulierbaren optischen Vorrichtung, die folgenden Schritte umfassend:

- Anordnen eines optischen Elements (1) innerhalb eines Hohlraums (4), der in einem Substrat (5) ausgebildet ist;
- Füllen des Hohlraums (4) mittels einer Matrix (2), die bei einer ersten Temperatur fest ist und unter der Wirkung einer Erhöhung der Temperatur erweichen kann;
- nötigenfalls Erhöhen der Temperatur bis zum Erweichen der Matrix (2);
- Einwirken auf das Element (1) von außen her, um es innerhalb der Matrix (2) zu verlagern;
- Senken der Temperatur bis zur Erstarrung der Matrix (2).

**Claims**

1. A method for displacing an object in a solid system involving the following steps:

- placing the object (1) in a matrix (2) which is solid at a first temperature and capable of softening due to the effect of a temperature increase;
- if necessary, increasing the temperature until the matrix (2) softens;
- applying an external action to the object (1) so as to move it inside the matrix (2);
- lowering the temperature until the matrix (2) solidifies.

2. The method for displacing an object as claimed in claim 1, **_characterized_ in that** the object (1) is selected from the following group: silicon nano-wires, carbon nanotubes, micro battery, micro-cell, connector, optical lens, transistor electrode, optical filter.

3. The method for displacing an object as claimed in either claim 1 or 2, **_characterized_ in that** the matrix (2) is made of a polymer and the temperature is increased to the glass transition temperature (Tg) and/or melting temperature (Tf) of said polymer.

4. The method for displacing an object as claimed in claim 3, **_characterized_ in that** the matrix (2) is made of an ethylene and methyl acrylate copolymer or an ethylene and vinyl acetate copolymer.

5. The method for displacing an object as claimed in any of the above claims, **_characterized_ in that** an electric or magnetic action, advantageously exerted using a magnet (3), is applied.

6. The method for displacing an object as claimed in any of the above claims, **_characterized_ in that** the object (1) is placed in a cavity (4) provided in a substrate (5) which is then filled with the matrix (2).

7. The method for displacing an object as claimed in claim 6, **_characterized_ in that** the substrate (5) has a softening temperature that is higher than that of the matrix (2) with the difference between these two temperatures advantageously being equal to or greater than 50 °C.

8. The method for displacing an object as claimed in claim 6 or 7, **_characterized_ in that** the substrate (5) is made of a plastic material, advantageously polyethylene naphthalate (PEN) or polyimide.

9. The method for displacing an object as claimed in any of the above claims, **_characterized_ in that** the matrix (2) and, if applicable the substrate (5), is/are covered or encapsulated in a layer (7).

10. A method for establishing variable connections between an object, advantageously a micro battery, and at least two feed points (A, B) of a system and involving the following steps:

- placing the object (1) inside a cavity (4) provided in a substrate (5), the walls whereof are covered, at least partially, in a metallic layer (6);
- filling the cavity (4) with a matrix (2) which is solid at a first temperature and capable of softening due to the effect of a temperature increase;
- if necessary, increasing the temperature until the matrix (2) softens;
- applying an external action to the object (1) in order to move it inside the matrix (2) to a point A or B located in the cavity (4) of the substrate (5);
- lowering the temperature until the matrix (2) solidifies.

11. A method for producing a variable-capacitance transistor which involves the following steps:

- placing a gate electrode (1) inside a cavity (4) provided in a substrate (5);

- filling the cavity (4) with a matrix (2) which is solid at a first temperature and capable of softening due to the effect of a temperature increase;
- if necessary, increasing the temperature until the matrix (2) softens;
- applying an external action to the gate (1) so as to move it inside the matrix (2);
- lowering the temperature until the matrix (2) solidifies.

12. A method for producing an adjustable optical device involving the following steps:

- depositing an optical element (1) inside a cavity (4) provided in a substrate (5);
- filling the cavity (4) with a matrix (2) which is solid at a first temperature and capable of softening due to the effect of a temperature increase;
- if necessary, increasing the temperature until the matrix (2) softens;
- applying an external action to the optical element (1) so as to move it inside the matrix (2);
- lowering the temperature until the matrix (2) solidifies.

Fig. 1A

Fig. 1B

Fig. 1C

Fig. 1D

Fig. 1E

Fig. 1F

Fig. 1G — Polymère Solide — Chauffage à 75°C — Polymère liquide — Fig. 1H

Fig. 1I — Polymère liquide — Chauffage à 75°C — Polymère liquide — Fig. 1J

**Fig. 2A**

**Fig. 2B**

**Fig. 2C**

Polymère solide

**Fig. 2D**

Polymère solide

**Fig. 2E**

Polymère liquide

**Fig. 2F**

Modulation de l'épaisseur du diélectrique dans les 3D

modification des performances électriques du transistor

**Fig. 2G**

**Fig. 2H**

Polymère liquide

**Fig. 2I**

lumière

1  2  5

**Fig. 3A**

lumière

**Fig. 3B**

**EP 2 436 513 B1**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 2014611 A2